# EUROPEAN PATENT APPLICATION

(11) **EP 4 207 537 A1**
(43) Date of publication of application: **05.07.2023**
(21) Application number: 21218153.1
(22) Date of filing: 29.12.2021
(51) Int. Cl.: H02J 7/00, G01R 31/36, G01R 31/392

(54) **METHOD AND BATTERY MODULE WITH STATE OF HEALTH DETERMINATION**

(71) Applicant: Polarium Energy Solutions AB, 164 21 Kista (SE)
(72) Inventor: KROHN, Ulf, 164 21 KISTA (SE); FORSLÖF, Johan, 164 21 KISTA (SE); DUNGE, Andreas, 164 21 KISTA (SE)
(74) Representative: AWA Sweden AB

(57) **Abstract**

A battery module (100) is provided. The battery module comprises a battery unit (204) arranged to receive an input power from an external power source. In absence of the input power, the battery unit is arranged to supply power to a load. The battery module further comprises a control unit (202) configured to, in presence of the input power, perform a charging cycle comprising charging (4010) the battery unit, using the input power, to a first predetermined level (l₁). The charging cycle further comprises disconnecting (4030) the battery unit from the input power once the first predetermined level is reached. The charging cycle further comprises allowing (4040) the battery unit to discharge to a second predetermined level (l₂) and, once the second predetermined level is reached: determining (4052) a discharge time (t_{d}) for the battery unit from the first predetermined level to the second predetermined level, determining (4054) a state of health of the battery unit based on the determined discharge time, and reconnecting (4060) the battery unit to the input power for recharging the battery unit to the first predetermined level.

## Description

### Technical field

The present disclosure relates generally to the field of battery modules. More specifically it relates to monitoring a state of health of a battery module, particularly a battery module including a battery unit comprising lithium ion-based battery cells.

### Background

In many applications, batteries are used as a backup in case of failure of a power supply, for example in the form of uninterruptible power supplies. In areas having stable power grids, such backup batteries may be used less than once a year. When the battery is not in use, the state of health (SoH) and functionality of the battery is often not known. Therefore, the battery may not function as desired when a power failure occurs, and the powered equipment may go down. Further, keeping lithium-ion battery cells at a constant high state of charge (SoC) reduces the lifetime of the battery cells.

### Summary

It is therefore an object of the present invention to overcome at least some of the above-mentioned drawbacks, and to provide an improved battery module and an improved method for operating a battery unit.

This and other objects are achieved by means of a device and a method as defined in the appended independent claims. Other embodiments are defined by the dependent claims.

According to a first aspect of the present disclosure, a battery module is provided. The battery module comprises a battery unit arranged to receive an input power from an external power source and, in absence of the input power, supply power to a load. The battery module further comprises a control unit configured to perform a charging cycle when said input power is available.

The charging cycle comprises charging the battery unit to a first predetermined level, by using (drawing power from) the external power source, i.e. using the input power. The charging cycle further comprises disconnecting the battery unit from the input power once the first predetermined level is reached. Further, the charging cycle comprises allowing the battery unit to discharge to a second predetermined level.

Once the battery unit has discharged to the second predetermined level, the control unit is configured to determine a discharge time for the battery unit to reach the second predetermined level from the first predetermined level (i.e. the time to discharge from the first predetermined level to the second predetermined level). Further, the control unit is configured to determine a state of health (SoH) of the battery unit based on the determined discharge time. The charging cycle further comprises reconnecting the battery unit to the input power for recharging the battery unit to the first predetermined level.

The battery module may, for example, be arranged as part of an uninterruptable power supply for the load. In such an arrangement, the external power source may be arranged to provide the input power to the battery module and to power the load. When the external power source is active, the load is powered, and the battery unit of the battery module may be charged in parallel. If the external power source fails to provide power, such as for example during a power cut, the battery module loses its input power, and the load loses its power. The battery module may then automatically provide power to the load, such that the load remains in function.

It is generally desired to extend the lifetime of battery modules. For battery modules arranged as backup for powering a load in case of failure of a main power supply or an external power source, it is also desired that the battery module has a high level of charge (state of charge, SoC), when the main power supply fails. However, keeping lithium ion-based battery cells at a high state of charge may reduce the lifetime of the battery cells.

In the present disclosure, a battery module is disclosed which may provide a high level of charge of the battery unit in case the input power disappears, such as if the external power source fails, while at the same time providing an extended lifetime of the battery module. For this purpose, when an input power is received at the battery module, the battery module is subject to a charging cycle including periods during which the battery unit of the battery module is discharged such that it is not constantly maintained at its maximum (or a very high) level of charge.

The charging cycle typically includes periods during which the battery unit is discharged from a high level of charge to a lower level of charge and periods during which the battery unit is charged (or recharged) from the lower level of charge to the high level of charge. These periods may be repeated sequentially (i.e. discharge, charge, discharge, charge).

Further, the battery module may provide information relating to the state of health of the battery module when it is not used to power the load.

The state of charge, i.e. the level of charge, of the battery unit may be determined in different ways. For example, the state of charge may be determined by measuring the voltage of the battery unit and by using a known curve (preferably a known discharge curve) relating the voltage of the battery unit to its state of charge. In other words, the voltage measured at the battery unit indicates the state of charge of the battery unit.

Generally, for determining the state of health of a battery unit, the state of charge of the battery unit may be measured before and after a known energy amount is required to be delivered by the battery unit. A comparison may then be made between an expected state of charge of the battery unit with the measured state of charge of the battery unit after the known energy amount has been delivered by the battery unit. For example, assuming that the state of charge of a battery unit initially varies from 80% to 70% to deliver a certain energy amount, if the state of charge of the battery unit varies from 80% to 65% at a later time, the state of health of the battery unit has become reduced.

For the purpose of measuring the state of health of a battery unit, the battery unit may be discharged using a known load for a known period of time (thereby determining a known energy amount to be delivered), after which the voltage (i.e. the state of charge) of the battery unit is measured and is compared with an expected voltage (i.e. an expected state of charge) of the battery unit.

As the battery unit ages, a larger portion of the total stored energy will be required to run the known period of time. As a result, the voltage at the end of the (known) discharge period will become lower and lower the older the battery unit gets.

In the embodiments according to the first aspect, the same general principle is applied in that a discharge time is determined for the battery unit to reach the second predetermined level from the first predetermined level. The first and second predetermined levels are obtained by measuring the voltage levels at the battery unit. If the discharge time for reaching the second predetermined level from the first predetermined level decreases between two measurements, this means that the state of health of the battery unit has decreased.

The battery unit may be discharged between the first predetermined level and the second predetermined level with a known load. The discharge time may be compared with earlier measured values for obtaining the same discharge of the battery unit. The state of health may then be determined based on a comparison between the measured discharge time and an expected discharge time.

The state of charge is defined relative to the present state of health of the battery unit. In other words, 100% SoC means that the battery unit is fully charged, at its present capacity. Considering, for example, an (ideal) battery unit with an initial (beginning of life, BOL) capacity of 100 Ah. At the beginning of its lifetime (t_{BOL}), discharging the battery unit from a fully charged state (SoC 100%), with a constant current of 1 A for 10 hours, would result in the remaining capacity being 90 Ah (SoC 90%).

However, the SoH of the battery unit may decrease over time, for example due to environmental conditions, power surges or general aging. The SoH is a measure of the condition of a battery (e.g. battery unit) compared to its ideal conditions. The SoH may be, at least in part, related to the actual capacity of the battery unit, as compared with the initial (ideal) capacity.

Therefore, if the same discharge procedure is repeated at a later time (t_{AGE}), when the SoH and the capacity of the battery has decreased, the results may be different. If the aged battery unit has a total capacity of 90 Ah, due to aging, the fully charged state (SoC 100%) corresponds to 90 Ah capacity. Discharging the battery unit with a constant current of 1 A for 10 h would result in a remaining capacity of 80 Ah, corresponding to 88% SoC. At t_{AGE}, a SoC of 90% corresponds to a remaining capacity of 81 Ah. Therefore, at t_{AGE}, a shorter discharge time, namely 9h, is required for the battery unit to reach the level of 90% SoC (i.e. 81 Ah), using the constant current of 1A. The present capacity of the battery unit may be estimated by comparing the determined discharge time t_{d} with initial values, or earlier values. From the actual capacity, the SoH of the battery unit may be determined.

Different methods for determining the state of health are available. The SoH may, for example, be calculated using aging data which is provided by the cell manufacturer. Alternatively, the actual capacity may be determined and compared with the initial capacity of the battery cells. More precise values may be reached by using both values determined using aging data and values determined based on the capacity comparison.

The procedure for determining the state of health of the battery module is introduced as a part of the charging cycle in that the state of health is determined based on the discharge time between the first predetermined level and the second predetermined level. Including this procedure as a part of the charging cycle is beneficial in that it is less invasive than other methods in which the battery module may have to perform a separate procedure and, in some cases, also requires to disconnect the battery module from the load, thereby losing its functionality as backup during the procedure for determination of the state of health of the battery module.

When the battery module receives the input power, the control unit may be configured to continuously (or repeatedly) perform the charging cycle. In this charging cycle, the battery unit is first charged to the first predetermined level of state of charge (SoC). This first predetermined level may be a high level, i.e. reaching almost 100%. When the battery unit has reached the first level, the battery unit is disconnected from the input power. When the battery unit is disconnected from the input power, the battery unit may begin to discharge. The discharge of the battery unit may for example be due to the stand-by power consumption from the control unit (or controller, also named battery management system, BMS) of the battery module. In other words, the discharge of the battery unit may be due to power consumption from internal components or units of the battery module.

As another alternative, a dedicated load or resistance may be provided for discharging the battery unit.

Once the battery unit has been discharged to the second predetermined, lower level, the input power is reconnected, and the battery unit may be recharged back up to the first predetermined level.

The determination of the discharge time, and thereby the determination of the state of health, may be performed while the battery unit is being recharged.

Using a charging/discharging cycle may prolong the lifetime of the battery unit, as the battery is not kept at maximum capacity for long periods of time.

Further, allowing the battery unit to self-discharge, and/or to discharge using internal units (components/equipment) may result in the battery unit discharging at a slow, steady and/or controlled rate. Such a discharge rate may allow for a reliable discharge time measurement, and lead to an improved SoH estimate.

As mentioned above, combining the charging cycle and the SoH estimation is beneficial. In particular, it may provide that the SoH estimation can be performed repeatedly without interrupting the power supply to the load. If desired, the SoH may in principle be determined for every charging cycle. The frequency at which the SOH is estimated may naturally be configured (i.e. every charging cycle or with a certain number of charging cycles between two estimations). When the SoH is continuously or repeatedly determined, changes in the SoH may be monitored, and planning of maintenance may be facilitated. The risk of the battery unit not functioning when it is needed may therefore be reduced.

According to some embodiments, the first predetermined level may be 95% or higher.

Allowing the battery unit to be initially charged to a high level, or to full capacity, before discharging means that the discharge may start from a high level. The battery unit may, thus, be discharged during the charging cycle and still retain enough charge to power the load. Consequently, the battery module may be in a state suitable for providing power to the load at all times during the charging cycle. For example, the first predetermined level may correspond to the battery being fully charged, such as the state of charge (SoC) being 100%.

According to some embodiments, the second predetermined level may be 70% or higher.

The second predetermined level may be selected such that it corresponds to a shallow discharge of the battery unit. Hence, in case the external power supply fails when the battery unit has discharged to the second predetermined level during the charging cycle, enough battery power remains to power the load for some time. The second predetermined level may therefore be selected based on a desired (or required) operation time of the battery module as backup in case of power failure of the external power source.

The second predetermined level may also be selected such that it is low enough for a reliable determination of the SoH of the battery unit, i.e. for a reliable voltage measurement of the capacity of the battery unit to be achieved.

In other examples, the second predetermined level may be 80% or higher, such as 90% or higher.

According to some embodiments, the control unit may be powered by the battery unit and the discharge of the battery unit between the first predetermined level and the second predetermined level may include discharging power from the battery unit to the control unit.

The power consumption of the control unit (or BMS) may be known and the control unit drawing power from the battery unit may provide for a more controlled and/or more predictable discharge of the battery unit. Therefore, the estimation of the state of health may be improved.

According to some embodiments, the battery module may further comprise an adjustable load resistance. The control unit may further be configured to discharge the battery unit to the second determined level using the adjustable load resistance.

The adjustable load resistance may be adjusted to keep the discharge rate in a predefined or desired interval, which may improve the SoH estimation.

Alternatively or additionally, the battery module may further comprise a (non-adjustable) load resistance, which may be used in discharging the battery unit to the second determined level.

According to some embodiments, the control unit may further be configured to transmit information relating to the state of health to an external recipient.

For example, the control unit may be configured to transmit this information to an operator of the battery module and/or of the load. In many cases, battery modules are used as backup power sources for important infrastructure in remote locations. Access to the site may be difficult. Visits to the site, for example for maintenance or inspection, may be rare. Providing information relating to the SoH of the battery module/unit, may allow a remote operator to plan maintenance and/or replacement in due time.

According to some embodiments, the information relating to the state of health may comprise a warning message if the determined state of health is below a predetermined threshold.

According to some embodiments, the load may be a piece of telecommunication equipment.

Battery modules used as a backup power source may for example be employed to ensure that important infrastructure remains functional in case of a blackout. Telecommunication equipment such as a telecommunication base station is one example of such an important part of infrastructure. In a crisis, such as e.g. after an earthquake, a storm or other natural disaster which may result in a blackout, telecommunication is especially important to coordinate rescue and restoration activities. Further, as communication is needed also in inaccessible areas, telecommunication equipment may be located at remote sites.

According to a second aspect of the present disclosure, a method for operating a battery unit is provided. The battery unit is arranged to receive an input power from an external power source and, in absence of the input power, to supply power to a load. The method comprises, when the input power is available, performing a charging cycle. The charging cycle comprises charging the battery unit to a first predetermined level using the input power (i.e. drawing power from the external power source). The charging cycle further comprises disconnecting the battery unit from the input power once the first predetermined level is reached. The charging cycle further comprises allowing the battery unit to discharge to a second predetermined level. Once the second predetermined level has been reached, the charging cycle further comprises determining a discharge time for the battery unit from the first predetermined level to the second predetermined level and determining a state of health of the battery unit based on the determined discharge time. The charging cycle further comprises reconnecting the battery unit to the input power for recharging the battery unit to the first predetermined level.

As described above with reference to embodiments of the first aspect of the disclosure, according to some embodiments, the first predetermined level may be 95% or higher.

According to some embodiments, the second predetermine level may be 70% or higher.

It will, in general, be appreciated that the explanations and advantages discussed with reference to the first aspect of the disclosure apply mutatis mutandis to the second aspect of the disclosure.

According to some embodiments, the discharging may include supplying power to a control unit of a battery module in which the battery unit is arranged.

The method may for example be implemented in, and/or performed by, the control unit.

According to some embodiments, the method may further comprise discharging the battery unit to the second predetermined level using an adjustable load resistance.

The method may further include adjusting the adjustable load resistance. For example, the adjustable load resistance may be adjusted to achieve a desired discharge rate.

According to some embodiments, the method may further comprise transmitting information relating to the state of health to a recipient.

Any embodiment described herein with respect to the first aspect of the present disclosure may be combinable with other embodiments also described herein, e.g. with respect to the second aspect of the present disclosure, and vice versa, and the present disclosure relates to all combinations of features.

### Brief description of drawings

Exemplifying embodiments will now be described in more detail, with reference to the following appended drawings:
Figure 1 is a schematic illustration of a power installation for a load comprising a battery module in accordance with some embodiments;
Figure 2 is a schematic illustration of a battery module in accordance with some embodiments;
Figure 3 is a graph illustrating a charging cycle, in accordance with some embodiments;
Figure 4 is a flowchart illustrating a charging cycle of a method for operating a battery unit, in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

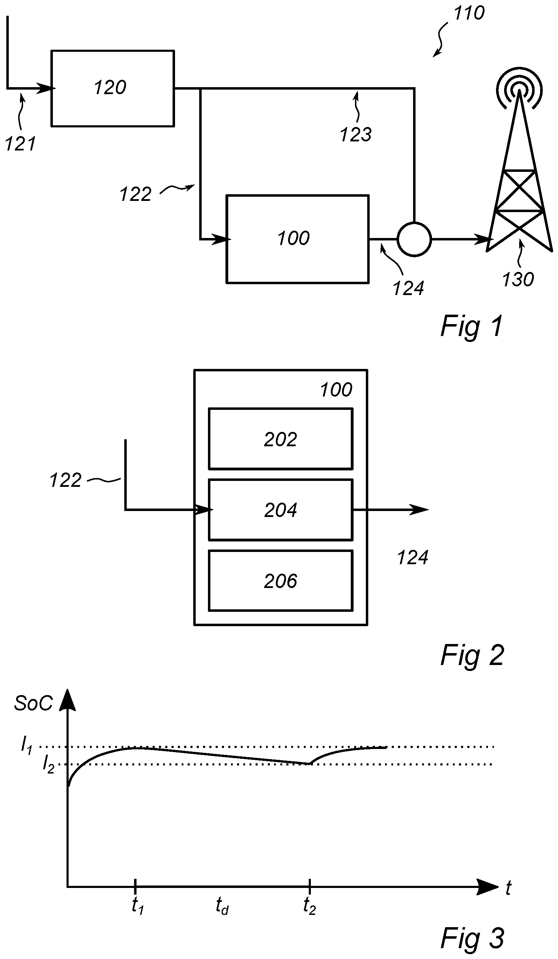

With reference to Figure 1, a power installation comprising a battery module, in accordance with some embodiments, will be described.

Figure 1 is a schematic illustration of a power installation 110 (or power system) for powering a load 130. In the present example, the load 130 is a piece of telecommunication equipment such as a base station.

The power installation 110 receives power 121 from an external power source, such as a main power source, a power grid, a power generator, or an external battery. The received power 121 may be converted in an (optional) power supply unit 120 or converter. For example, the power supply unit 120 may receive AC voltage at 90-440 V, 50-60 Hz, or DC voltage at 100-500 V. The power supply unit 120 may convert the received power to e.g. 24 V DC or 48 V DC, or any power suitable for powering the load 130.

During normal operation, the load 130 is powered by the (potentially converted) received power 123. However, when no power 121, or insufficient power, is received, the load 130 is powered by the battery module 100.

The battery module 100 may be arranged such that when the input power 122 (to the battery module 100) disappears, the battery module 100 automatically starts feeding power 124 to the load 130.

With reference to Figures 2-4, a battery module 100, and a method for operating a battery unit, in accordance with some embodiments, will be described.

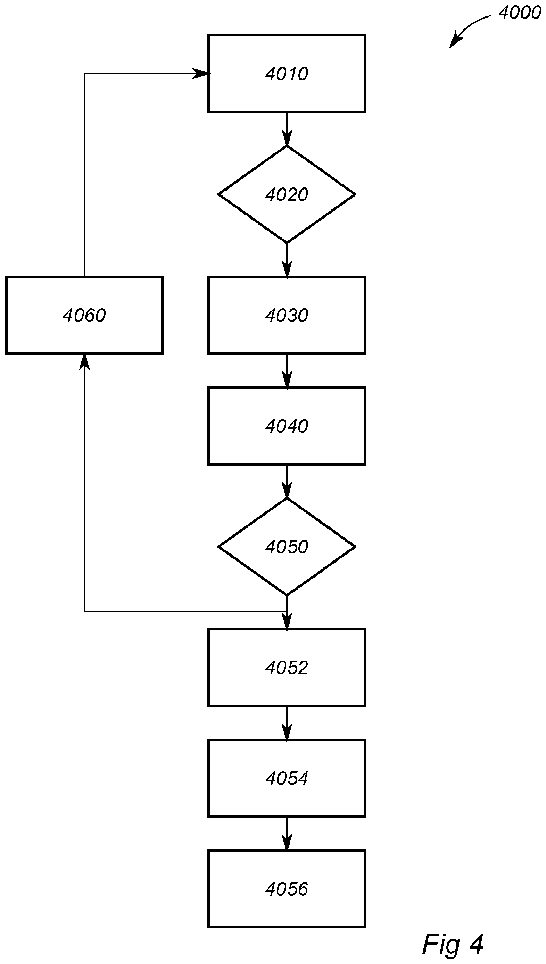

Figure 2 is a schematic illustration of a battery module 100. The battery module 100 receives an input power 122, from an external power source, which may be used to charge the battery unit 204 of the battery module. When the input power 122 is not available, e.g. due to the external power source failing, the battery unit 204 may provide an output power 124 to the load 130. When the input power 122 is present, i.e. when the external power supply supplies power to the battery, the controller 202 of the battery module is configured to perform a charging cycle 4000, as illustrated in the flowchart shown in Figure 4 and in the graph of Figure 3.

During the charging cycle 4000, the battery unit 204 is charged at 4010 to a first level or state of charge (SoC) l₁. When it is detected at 4020 that the first level l₁ has been reached (at time ti), for example by a voltage measurement of the battery unit 204, the battery unit 204 is disconnected at 4030 from the input power 122 and allowed to discharge at 4040.

The discharge at 4040 may be due to self-discharge, i.e. the battery unit 204 discharging without any connection between the electrodes or any external circuit, often due to internal chemical reactions.

Further, the controller 202 may be powered by the battery unit 204. The discharge may then be due at least in part to the self-discharge of the battery unit and the power consumption by the controller, which may increase the rate of discharge.

Alternatively, the battery module 100 may further comprise an adjustable load resistance 206 which may be used to improve control of the discharge rate. For example, the adjustable load resistance 206 may comprise a network of resistors which may be switched in and out to adapt the resistance of the network. Alternatively, the adjustable load resistance 206 may be part of a cell balancing resistor network, used to balance the charge between individual cells of the battery unit 204. The controller 202 may be further adapted to control the adjustable load resistance 206. As a further option, the battery module may comprise a (non-adjustable) load resistance (not illustrated), used for discharging the battery unit from the first level to the second level.

When the battery unit 204 has been discharged to the second level l₂ (at time t₂, step 4050), the battery unit 204 is reconnected (step 4060) to the input power 122 and allowed to (re-)charge at 4010 to the first level l₁ again. Further, a discharge time t_{d} is determined at 4052. The discharge time t_{d} is the time necessary for the battery unit 204 to discharge from the first level l₁ to the second level 12.

The discharge time t_{d} is related to the state of health (SoH) of the battery unit 204.

The beginning of life (BOL) capacity of the battery unit is known. As the battery ages, the discharge time from the first level l₁ (e.g. full charge) to the second level 12, for a given load/discharge rate, will become shorter, as the capacity of the battery unit decreases. The actual (current/present) capacity of the battery unit may be estimated by comparing the determined discharge time t_{d} with initial values, or earlier values. From the actual capacity, the SoH of the battery unit may be determined.

Based on the determined discharge time t_{d}, a state of health of the battery unit 204 is determined 4054. Information relating to the SoH may (optionally) be transmitted 4056 to a recipient.

The method and battery module 100 described with reference to Figures 1-4 may provide that the state of health of the battery unit 204 is repeatedly determined. Therefore, changes in the SoH may be monitored, and planning of maintenance may be facilitated. Further, the risk of the battery unit not functioning when it is needed may be reduced.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A battery module (100) comprising:
a battery unit (204) arranged to receive an input power from an external power source and, in absence of said input power, supply power to a load; and
a control unit (202) configured to, in presence of said input power, perform a charging cycle comprising:
charging (4010) said battery unit, using the input power, to a first predetermined level (l₁);
disconnecting (4030) said battery unit from the input power once the first predetermined level is reached;
allowing (4040) said battery unit to discharge to a second predetermined level (l₂) and, once the second predetermined level is reached:
determining (4052) a discharge time (t_{d}) for the battery unit to reach the second predetermined level from the first predetermined level,
determining (4054) a state of health of the battery unit based on the determined discharge time, and
reconnecting (4060) said battery unit to the input power for recharging the battery unit to the first predetermined level.

2. The battery module of claim 1, wherein said first predetermined level is 95% or higher.

3. The battery module of any of the preceding claims, wherein said second predetermined level is 70% or higher.

4. The battery module of any of the preceding claims, wherein said control unit is powered by said battery unit and the discharge of the battery unit between the first level and the second level includes discharging power from the battery unit to the control unit.

5. The battery module of any of the preceding claims, further comprising an adjustable load resistance (206), wherein said control unit is further configured to discharge said battery unit to the second predetermined level using said adjustable load resistance.

6. The battery module of any of the preceding claims, wherein said control unit is further configured to transmit (4056) information relating to said state of health to an external recipient.

7. The battery module of claim 6, wherein said information relating to the state of health comprises a warning message if the determined state of health is below a predetermined threshold.

8. The battery module of any of the preceding claims, wherein said load (130) is a piece of telecommunication equipment.

9. A method for operating a battery unit arranged to receive an input power from an external power source and to supply power to a load, the method comprising, in presence of said input power, performing a charging cycle comprising:
charging (4010) said battery unit to a first predetermined level using said input power;
disconnecting (4030) said battery unit from said input power once the first predetermined level is reached;
allowing (4040) said battery unit to discharge to a second predetermined level and, once the second predetermined level has been reached:
determining (4052) a discharge time for the battery unit to reach the second predetermined level from the first predetermined level;
determining (4054) a state of health of the battery unit based on the determined discharge time, and
reconnecting (4060) said battery unit to the input power for recharging the battery unit to the first predetermined level.

10. The method of claim 9, wherein said first predetermined level is above 95%.

11. The method of any of claims 9-10, wherein said second predetermined level is above 70%.

12. The method of any of claims 9-11, wherein the discharging to the second predetermined level includes supplying power to a control unit of a battery module in which the battery unit is arranged.

13. The method of any of claims 9-12, further comprising, discharging said battery unit to said second predetermined level using an adjustable load resistance.

14. The method of any of claims 9-14, further comprising transmitting (4056) information relating to said state of health to a recipient.

15. The method of claim 14, wherein said information relating to the state of health comprises a warning message if the determined state of health is below a predetermined threshold.
